Europäisches Patentamt

**European Patent Office**

Office européen des brevets

(11) Numéro de publication: **0 232 436**
B1

(12) FASCICULE DE BREVET EUROPEEN

(45) Date de publication du fascicule du brevet:
24.01.90

(51) Int. Cl.⁴: **C30B 23/06**, C30B 29/40

(21) Numéro de dépôt: 85402240.7

(22) Date de dépôt: 19.11.85

(54) Générateur de jets moléculaires par craquage thermique pour la fabrication de semi-conducteurs par dépôt épitaxial.

(43) Date de publication de la demande:
19.08.87 Bulletin 87/34

(45) Mention de la délivrance du brevet:
24.01.90 Bulletin 90/4

(84) Etats contractants désignés:
AT BE CH DE GB IT LI NL SE

(56) Documents cités:
FR-A- 2 572 099
GB-A- 2 080 271

JOURNAL OF APPLIED PHYSICS,
vol. 55, no. 10, 15 mai 1984, pages 3571-3576, American
Institute of Physics, New York, US; M.B. PANISH et al.:
"Gas source molecular beam epitaxy of
GaxInl-xPyAsl-y"

(73) Titulaire: **COMPAGNIE GENERALE D'ELECTRICITE
Société anonyme dite:, 54, rue La Boétie, F-75382 Paris
Cédex 08(FR)**

(72) Inventeur: **Huet, Daniel, 34 rue du Donjon,
F-77310 Boissise Le Roi(FR)**
Inventeur: **Lambert, Marc, 3 rue St Laurent,
F-91400 Orsay(FR)**

(74) Mandataire: **Weinmiller, Jürgen et al,
Lennéstrasse 9 Postfach 24, D-8133 Feldafing(DE)**

## Description

La présente invention concerne un générateur de jets moléculaires par craquage thermique pour la fabrication de semi-conducteurs par dépôt épitaxial. Elle s'applique plus particulièrement à la fabrication de couches de semi-conducteurs du type III-V telles que celles qui sont formées par des alliages Ga As, Ga Al As, In Ga As, In Ga As P, In Ga Al As, et qui sont incorporées dans des hétérostructures monocristallines pour constituer des composants utilisés en optoélectronique. La réalisation de telles couches nécessite l'utilisation de jets de molécules d'éléments du type V, tels que l'arsenic et le phosphore, qui sont très volatils, et qui doivent présenter une très haute pureté (7N).

Le dépôt épitaxial par jets moléculaires (en anglais "Molecular beam epitaxy") consiste à condenser les éléments de la couche que l'on désire former sur un substrat monocristallin porté à une température de l'ordre de 500 C sous ultravide ($10^{-10}$ torr).

Les débits des jets moléculaires de chacun des éléments d'un alliage doivent pouvoir être commandés avec précision. Ils sont très différents même lorsqu'il s'agit de deux éléments seulement, l'un de la colonne III, l'autre de la colonne V de la table de Mendeleïeff, car les tensions de vapeur et les probabilités de condensation sont eux mêmes très différents. C'est pourquoi, en ce qui concerne les éléments de la colonne V, plutôt que de former des molécules de phosphore ou d'arsenic par sublimation d'une charge solide de ces matériaux dans un creuset réfractaire, constitué par exemple de nitrure de bore pyrolytique, on a proposé un générateur de jet moléculaire comportant les éléments suivants :

- une source d'un gaz primaire capable de former par craquage diverses molécules secondaires aptes à se déposer épitaxialement sur un substrat cristallin pour contribuer à la fomation d'une couche semi-conductrice,
- une vanne commandant le débit de cette source,
- un conduit de craquage chaud à paroi réfractaire présentant une entrée et une sortie et parcouru par ledit gaz primaire, en aval de cette vanne pour assurer le craquage thermique de ce gaz par contact avec cette paroi et former ainsi lesdites molécules secondaires avec un débit commandé par cette vanne,
- un filament de chauffage entourant ce conduit de craquage et parcouru par un courant électrique pour assurer par rayonnement un chauffage sensiblement homogène des parois de ce conduit à une température assurant sélectivement la formation de celles desdites molécules secondaires qui contribuent le plus efficacement à la formation de ladite couche semi-conductrice,
- un réflecteur de chaleur entourant ledit filament de chauffage de manière à augmenter son efficacité et à rendre plus homogène la température des parois dudit conduit de craquage,
- et des moyens directifs de formation de jet disposés à l'aval de ce conduit de craquage pour former avec ces molécules secondaires un jet moléculaire dirigé vers un dit substrat dans une enceinte vidée de gaz,

Ce générateur est connu par l'article du JOURNAL OF APPLIED PHYSICS, vol. 55, no. 10, 15 mai 1984, pages 3571-3576, American Institute of Physics, New York, US ; M.B. PANISH et al.: "Gas source molecular beam epitaxy of $Ga_xIn_{1-x}P_yAs_{1-y}$".

Dans ce générateur connu le gaz primaire circule dans un conduit de craquage tubulaire et l'inconvénient apparaît que le jet moléculaire formé contient des proportions plus ou moins incorrectes de molécules des divers nombres d'atomes possibles, tels que $P_2$, $P_4$, etc..., et ceci quelque soit le choix de la puissance de chauffage.

La présente invention a pour but d'obtenir de manière simple un jet moléculaire, notamment d'arsenic ou de phosphore, qui présente une composition prédéterminée.

Elle a pour objet un générateur de jets moléculaires par craquage thermique pour la fabrication de semi-conducteurs par dépôt épitaxial. Ce générateur comporte :
- une source (22) d'un gaz primaire capable de former par craquage diverses molécules secondaires aptes à se déposer épitaxialement sur un substrat cristallin pour contribuer à la formation d'une couche semi-conductrice,
- une vanne (20) commandant le débit de cette source,
- un conduit de craquage chaud (11) à paroi réfractaire présentant une entrée et une sortie et parcouru par ledit gaz primaire, en aval de cette vanne pour assurer le craquage thermique de ce gaz par contact avec cette paroi et former ainsi lesdites molécules secondaires avec un débit commandé par cette vanne,
- un filament de chauffage (30) entourant ce conduit de craquage et parcouru par un courant électrique pour assurer un chauffage sensiblement homogène des parois de ce conduit à une température assurant sélectivement la formation de celles desdites molécules secondaires qui contribuent le plus efficacement à la formation de ladite couche semi-conductrice,
- et des moyens directifs de formation de jet (6s) disposés à l'aval de ce conduit de craquage pour former avec ces molécules secondaires un jet moléculaire dirigé vers un dit substrat dans une enceinte vidée de gaz, (Les numéros de référence renvoient aux figures ci-jointes).

Ce générateur est caractérisé par le fait que ledit conduit de craquage (11) présente la forme d'un corps allongé sensiblement cylindrique ou prismatique muni d'une succession longitudinale de cloisons transversales intérieures (6a, 6b, 6c, 6d) qui forment une succession de chambres communiquant par une succession d'orifices de communication (6p, 6q, 6r, 6s), les aires des sections de passage de ces orifices étant inférieures au quart de l'aire de la section intérieure de ce corps, de manière à accroître le nombre des chocs des molécules du gaz primaire sur les parois de ce conduit.

Selon la présente invention il est de plus apparu avantageux d'adopter, au moins dans certains cas, les dispositions plus particulières suivantes :

- Lesdits orifices de communication successifs (6p, 6q, 6r, 6s) sont placés au voisinage de génératrices différentes du corps (11) du conduit de craquage pour empêcher une molécule du gaz primaire de parcourir ce conduit en ligne droite.

- Lesdits moyens directifs de formation de jet comportent plusieurs dits orifices (6s) répartis dans la surface de la dernière (6d) desdites cloisons intérieures et un tronçon terminal (11a) dudit corps du conduit de craquage (11) en aval de cette cloison, de manière à former un jet homogène et d'étendue angulaire limitée.

- Ledit filament de chauffage (30) entoure sans contact ledit conduit de craquage (11) pour chauffer celui-ci par rayonnement, un réflecteur de chaleur (9) entourant ledit filament de chauffage (30) de manière à augmenter son efficacité et à rendre plus homogène la température des parois dudit conduit de craquage (11).

- Un conduit capillaire métallique (2) est connecté en aval de ladite vanne pour régulariser le débit dudit gaz primaire, ce conduit étant disposé à distance dudit conduit de craquage (11) pour éviter son échauffement, et étant suivi d'un conduit de raccordement (5) pour amener ce gaz au conduit de craquage.

A l'aide des figures schématiques ci-jointes on va décrire ci-après plus particulièrement, à titre d'exemple non limitatif, comment l'invention peut être mise en oeuvre. Il doit être compris que les éléments décrits et représentés peuvent, sans sortir du cadre de l'invention, être remplacés par d'autres éléments assurant les mêmes fonctions techniques. Lorsqu'un même élément est représenté sur plusieurs figures il y est désigné par le même signe de référence.

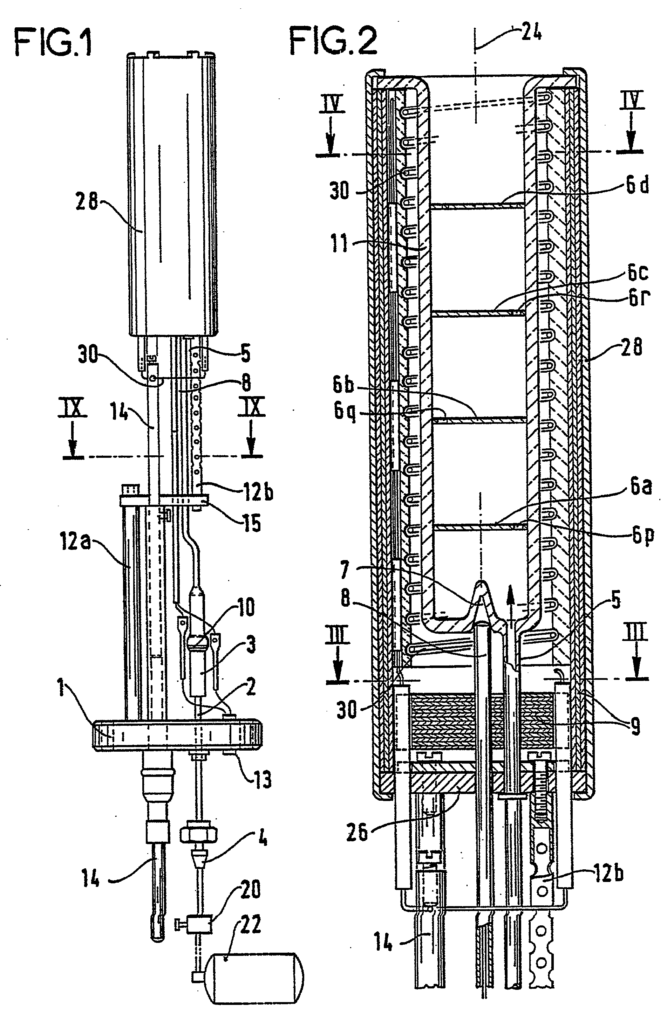

La figure 1 représente une vue générale en élévation d'un générateur selon l'invention.

La figure 2 représente une vue à échelle agrandie du conduit de craquage de ce générateur en coupe pour un plan passant par l'axe vertical de ce conduit.

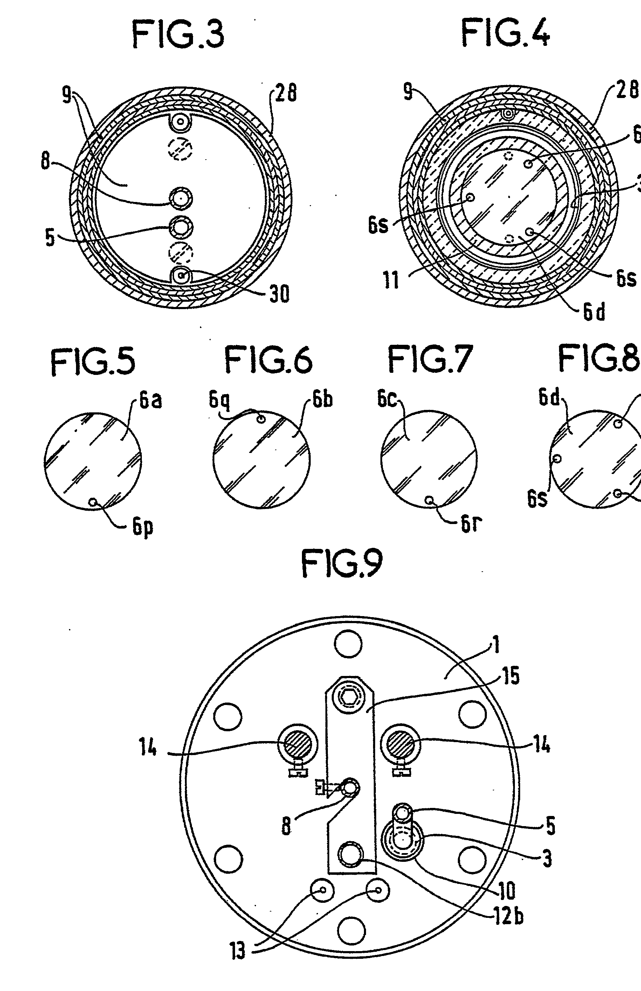

La figure 3 représente une vue de dessus de ce conduit en coupe par un plan horizontal III III de la figure 2.

La figure 4 représente une vue analogue à la figure 3, le plan horizontal de coupe étant le plan IV IV de la figure 2.

Les figures 5, 6, 7 et 8 représentent des vues de dessus des quatre cloisons intérieures de ce conduit de craquage.

La figure 9 représente une vue de dessus à échelle agrandie des organes de support et d'alimentation de ce conduit de craquage, en coupe par un plan horizontal IX IX de la figure 1.

Dans l'exemple décrit le gaz primaire est constitué de phosphine $PH_3$ et s'écoule de bas en haut de même que le jet moléculaire de phosphore auquel il donne naissance. Le générateur comporte les éléments suivants :

1/ Bride de support en acier inoxydable, assurant l'étanchéité de l'enceinte à ultravide non représentée dans laquelle vient se placer la source gazeuse. L'étanchéité est assurée par un joint en cuivre argenté, comprimé entre la bride 1 et une contre-bride solidaire de l'enceinte à ultra-vide.

2/ "Capillaire" (tube capillaire) en acier inoxydable NS 225 de diamètre extérieur 3,2 mm, soudé sur la bride 1. Ce capillaire permet l'injection du gaz de l'extérieur de l'enceinte vers le conduit de craquage, par l'intermédiaire d'une servo-vanne 20 commandée par une jauge de pression non représentée et disposée dans l'enceinte à ultravide, sur le trajet du jet moléculaire formé par le générateur.

3/ Manchon en acier inoxydable NS 225 permettant le raccordement entre le capillaire d'inox et un capillaire de quartz 5. Il est raccordé au capillaire d'inox par soudure autogène sous argon. Coté capillaire de quartz une soudure verre-métal 10 assure l'étanchéité.

4/ Raccord en acier inoxydable du type swagelock permettant la liaison du capillaire à la servo-vanne 20 commandant le débit du gaz à partir d'un réservoir sous pression 22 constituant ladite source de gaz primaire.

5/ Capillaire de quartz assurant le transport du gaz jusqu'au conduit de craquage 11, tout en évitant un échauffement excessif du capillaire 2.

6a, 6b, 6c, 6d/ Cloisons de quartz épaisses de 0,5 mm formant chicanes et situées dans le conduit de craquage pour assurer la thermalisation des molécules de gaz et leur craquage. Trois cloisons 6a, 6b, 6c comportent chacune un trou périphérique 6p, 6q, 6r, désaxé par rapport aux trous des autres cloisons. Ceci empêche la sortie directe de molécules à trajectoire rectiligne. Une cloison supérieure 6d comporte trois trous 6s décalés de 120°, de façon à rendre le jet moléculaire symétrique par rapport à l'axe vertical 24 du conduit de craquage 11. Le tronçon supérieur de ce conduit coopère avec ces trois trous pour former les moyens de formation de jet précédemment mentionné. Le diamètre de chacune de ces cloisons est très légèrement supérieur à celui de la précédente et le conduit 11 est légèrement conique, au moins quant à sa surface intérieure, ce qui permet de fixer ces cloisons dans ce conduit en les poussant à partir du tronçon supérieur, jusqu'à ce qu'elles soient bloquées par cette surface intérieure.

7/ Alvéole située au bas du conduit de quartz 11 et recevant un thermocouple 8 qui permet la mesure de la température de ce conduit.

8/ Thermocouple Tungstène - Rhénium 5% permettant la mesure et la régulation de la température du conduit de craquage à 0,1 degré près.

9/ Feuilles de tantale superposées pour renvoyer le rayonnement thermique du filament de chauffage en tantale 30, chauffé par effet Joule, vers le conduit de craquage, et constituer ledit réflecteur de chaleur. Certaines de ces feuilles entourent ce conduit, d'autres sont disposées sous sa base.

10/ Soudure verre-métal.

11/ Conduit de craquage en quartz recevant les cloisons 6 et formant ainsi quatre chambres successives de craquage. Il semble cependant qu'il sera avantageux de réaliser ce conduit et ces cloisons en nitrure de bore pyrolytique. Son épaisseur est de 1 mm, sa longueur de 89 mm et son diamètre extérieur de 20 mm. Son entrée est raccordée au capillaire 5. Sa sortie est formée par son tronçon supérieur 11a.

12a, 12b/ Colonnettes assurant la liaison mécanique entre la bride support et le conduit de craquage.

13/ Connexions électriques du thermocouple.

14/ Arrivées de courant au filament de chauffage 30.

15/ Platine de support du thermocouple.

20/ Servo-vanne réglant le débit du générateur.

22/ Réservoir de phosphine.

24/ Axe du conduit de craquage 11 et du jet moléculaire qui en sort.

26/ Embase métallique d'un tube métallique 28 contenant le conduit de craquage 11 et le réflecteur 9.

30/ Filament de chauffage en tantale assurant une température d'au moins 800°C, par exemple 900°C au conduit de craquage. Il est situé à 5 mm de la paroi de ce conduit pour que le chauffage se fasse par rayonnement et donne une température homogène. La puissance électrique consommée est par exemple de 80 watts.

## Revendications

1/ Générateur de jets moléculaires par craquage thermique pour la fabrication de semi-conducteurs par dépôt épitaxial,
ce générateur comportant
- une source (22) d'un gaz primaire capable de former par craquage diverses molécules secondaires aptes à se déposer épitaxialement sur un substrat cristallin pour contribuer à la formation d'une couche semi-conductrice,
- une vanne (20) commandant le débit de cette source,
- un conduit de craquage chaud (11) à paroi réfractaire présentant une entrée et une sortie et parcouru par ledit gaz primaire, en aval, de cette vanne pour assurer le craquage thermique de ce gaz par contact avec cette paroi et former ainsi lesdites molécules secondaires avec un débit commandé par cette vanne,
- un filament de chauffage (30) entourant ce conduit de craquage et parcouru par un courant électrique pour assurer un chauffage sensiblement homogène des parois de ce conduit à une température assurant sélectivement la formation de celles desdites molécules secondaires qui contribuent le plus efficacement à la formation de ladite couche semi-conductrice,
- et des moyens directifs de formation de jet (6s) disposés à l'aval de ce conduit de craquage pour former avec ces molécules secondaires un jet moléculaire dirigé vers un dit substrat dans une enceinte vidée de gaz,
- ce générateur étant caractérisé par le fait que ledit conduit de craquage (11) présente la forme d'un corps allongé sensiblement cylindrique ou prismatique muni d'une succession longitudinale de cloisons transversales intérieures (6a, 6b, 6c, 6d) qui forment une succession de chambres communiquant par une succession d'orifices de communication (6p, 6q, 6r, 6s), les aires des sections de passage de ces orifices étant inférieures au quart de l'aire de la section intérieure de ce corps, de manière à accroître le nombre des chocs des molécules du gaz primaire sur les parois de ce conduit.

2/ Générateur selon la revendication 1, caractérisé par le fait que lesdits orifices de communication successifs (6p, 6q, 6r, 6s) sont placés au voisinage de génératrices différentes du corps (11) du conduit de craquage pour empêcher une molécule du gaz primaire de parcourir ce conduit en ligne droite.

3/ Générateur selon la revendication 1, caractérisé par le fait que lesdits moyens directifs de formation de jet comportent plusieurs dits orifices (6s) répartis dans la surface de la dernière (6d) desdites cloisons intérieures et un tronçon terminal dudit corps du conduit de craquage (11) en aval de cette cloison, de manière à former un jet homogène et d'étendue angulaire limitée.

4/ Générateur selon la revendication 1 dans lequel ledit filament de chauffage (30) entoure sans contact ledit conduit de craquage (11) pour chauffer celui-ci par rayonnement,
- un réflecteur de chaleur (9) entourant ledit filament de chauffage (30) de manière à augmenter son efficacité et à rendre plus homogène la température des parois dudit conduit de craquage (11).

5/ Générateur selon la revendication 1, caractérisé par le fait qu'un conduit capillaire métallique (2) est connecté en aval de ladite vanne pour régulariser le débit dudit gaz primaire, ce conduit étant disposé à distance dudit conduit de craquage (11) pour éviter son échauffement, et étant suivi d'un conduit de raccordement (5) pour amener ce gaz au conduit de craquage.

6/ Générateur selon la revendication 1, caractérisé par le fait que le nombre desdites cloisons intérieures (6a, 6b, 6c, 6d) est de quatre au moins.

7. Générateur selon l'une des revendications précédentes, caractérisé en ce que ledit conduit de craquage (11) est légèrement conique et s'élargit, au moins quant à sa surface intérieure, le diamètre desdites cloisons intérieures successives (6a, 6b, 6c, 6d) croissant de manière correspondante dans le sens de circulation du gaz, ces cloisons étant fixées par blocage contre cette surface intérieure.

## Claims

1. A molecular beam generator using thermal cracking for manufacturing semiconductors by epitaxial deposition. Said generator comprising:
- a primary gas source (22) capable of forming various secondary molecules by thermal cracking, said molecules being suitable for being epitaxially deposited on a crystalline substrate in order to contribute to the formation of a semiconductor layer;
- a valve (20) controlling the yield of said source;
- a thermal cracking duct (11) downstream from said valve having a refractory wall, an inlet and an outlet, with said primary gas passing therethrough, in order to ensure thermal cracking of the gas by contact with the wall and thus to form said secondary molecules with a yield which is controlled by said valve;
- a heater filament (30) surrounding the thermal cracking duct and an electric current passing therethrough in order to substantially uniformly heat the walls of said duct to a temperature suitable for selectively forming those of said secondary molecules which contribute most effectively to the formation of said semiconductor layer; and
- beam-forming director means (6s) disposed downstream from the thermal cracking duct in order to form a molecular beam of said secondary molecules which is directed towards said substrate in an enclosure evacuated of gas, said generator being characterized in that said thermal cracking duct (11) is in the form of a substantially cylindrical or prismatic elongate body provided with a longitudinal succession of transversal partitions (6a, 6b, 6c, 6d) which form a succession of chambers communicating via a succession of orifices (6p, 6q, 6r, 6s), the cross-sectional areas of said orifices being less than one-fourth of the inside cross-sectional area of said body, thereby increasing the number of impacts between the molecules of the primary gas and the walls of said duct.

2. A generator according to claim 1, characterized in that said successive communication orifices (6p, 6q, 6r, 6s) are placed in the vicinity of different generating lines of the body (11) of the thermal cracking duct in order to prevent a molecule of primary gas from passing straight line through the duct.

3. A generator according to claim 1, characterized in that said jet-forming director means comprise a plurality of said orifices (6s) distributed over the surface of the last of said interior partitions (6d) and a terminal length of the body of said thermal cracking duct (11) downstream from said partition, thereby forming a uniform beam of limited angular extent.

4. A generator according to claim 1, characterized in that said heater filament (30) surrounds without direct contact said thermal cracking duct (11) in order to heat it by radiation, a heat reflector (9) surrounding said heater filament (30) in such a manner as to increase its efficiency and to make the temperature of the walls of the thermal cracking duct (11) more uniform.

5. A generator according to claim 1, characterized in that a metal capillary duct (2) is connected downstream from said valve in order to control the yield of said primary gas, said duct being disposed at a distance from the thermal cracking duct (11) in order to avoid being heated, and being followed by a connection line (5) to convey that gas to the thermal cracking duct.

6. A generator according to claim 1, characterized in that there are at least four inner partitions (6a, 6b, 6c, 6d).

7. A generator according to any one of the preceding claims, characterized in that said cracking duct (11) is slightly flared and widens at least on its inner side, the diameters of each of the successive inner partitions (6a, 6b, 6c, 6d) increasing correspondingly in the gas flow direction, said partitions being fixed by jamming at said inner surface.

## Patentansprüche

1. Molekularstrahlgenerator auf der Basis der thermischen Spaltung zur Erzeugung von Halbleitern durch epitaktisches Auftragen, mit
- einer Quelle (22) für ein Primärgas, das in der Lage ist, durch Spaltung verschiedene Sekundärmoleküle zu bilden, die sich epitaktisch auf einem kristallinen Substrat niederschlagen können, um die Bildung einer Halbleiterschicht zu unterstützen,
- einem Ventil (20) zur Steuerung der Abgabemenge dieser Quelle,
- einem heißen Spaltkanal (11) mit feuerfester Wandung stromabwärts des Ventils, der einen Einlaß und einen Auslaß aufweist und von dem Primärgas durchströmt wird, um die thermische Spaltung des Gases durch Kontakt mit der Wandung zu bewirken und auf diese Weise die Sekundärmoleküle mit einer durch das Ventil gesteuerten Abgabemenge zu bilden,
- einem den Spaltkanal umgebenden Heizdraht (30), der von einem elektrischen Strom durchflossen wird, um durch Strahlung eine im wesentlichen homogene Aufheizung der Kanalwände auf eine Temperatur durchzuführen, die selektiv die Bildung derjenigen Sekundärmoleküle ermöglicht, die am wirksamsten zur Bildung der Halbleiterschicht beitragen,
- und mit richtungsgebenden Mitteln (6s) für die Strahlbildung stromabwärts des Spaltkanals, um mit diesen Sekundärmolekülen einen auf das in einem entgasten Gefäß befindliche Substrat gerichteten Molekularstrahl zu bilden, dadurch gekennzeichnet, daß der Spaltkanal (11) die Gestalt eines länglichen, im wesentlichen zylindrischen oder prismatischen Körpers aufweist, der in Längsrichtung mit einer Folge von inneren Quertrennwänden (6a, 6b, 6c, 6d) versehen ist, die eine Folge von durch eine Folge von Verbindungsöffnungen (6p, 6q, 6r, 6s) miteinander in Verbindung stehenden Kammern bildet, wobei die lichten Durchtrittsquerschnitte dieser Öffnungen kleiner als ein Viertel des lichten inneren Querschnitts dieses Körpers sind, derart, daß die Anzahl der Aufprallstöße der Moleküle des Primärgases auf den Wänden des Kanals vergrößert wird.

2. Generator nach Anspruch 1, dadurch gekennzeichnet, daß die aufeinanderfolgenden Verbindungslöcher (6p, 6q, 6r, 6s) in der Nähe verschiedener Erzeugender des Körpers (11) dieses Spaltkanals angebracht sind, um ein Primärgasmolekül daran zu hindern, den Kanal in gerader Linie zu durchlaufen.

3. Generator nach Anspruch 1, dadurch gekennzeichnet, daß die richtungsgebenden Mittel für die Strahlbildung mehrere der Öffnungen (6s), die über die Oberfläche der letzten (6d) der inneren Quertrennwände verteilt sind, sowie einen Endabschnitt des Körpers des Spaltkanals (11) stromabwärts der Trennwand aufweisen, derart, daß ein homogener und hinsichtlich der winkelmäßigen Ausbreitung beschränkter Strahl gebildet wird.

4. Generator nach Anspruch 1, in dem der Heizdraht (30) berührungsfrei den Spaltkanal (11) umgibt, um diesen durch Strahlung aufzuheizen, wobei ein Wärmereflektor (9) den Heizdraht (30) in der Weise umgibt, daß seine Wirksamkeit erhöht und die Temperatur der Wände des Spaltkanals (11) gleichmäßiger gemacht wird.

5. Generator nach Anspruch 1, dadurch gekennzeichnet, daß eine metallische Kapillarleitung (2) stromabwärts des Ventils zur Regelung der Abgabemenge des Primärgases angeschlossen ist, wobei die Leitung zur Verhinderung ihrer Erwärmung in einer Entfernung vom Spaltkanal (11) angeordnet ist und an eine Anschlußleitung (5) übergeht, die das Gas in den Spaltkanal leitet.

6. Generator nach Anspruch 1, dadurch gekennzeichnet, daß die Anzahl der inneren Trennwände (6a, 6b, 6c, 6d) mindestens vier beträgt.

7. Generator nach einem der vorhergehenden Ansprüche, dadurch gekennzeichnet, daß der Spaltkanal (11) leicht konisch ausgebildet ist und sich mindestens bezüglich seiner Innenoberfläche erweitert, wobei die Durchmesser der aufeinanderfolgenden inneren Trennwände (6a, 6b, 6c, 6d) in entsprechender Weise in Richtung der Gasströmung zunehmen und diese Trennwände durch Blockierung an dieser Innenwand fixiert sind.

FIG.1

FIG.2

EP 0 232 436 B1

FIG.3

FIG.4

FIG.5 FIG.6 FIG.7 FIG.8

FIG.9